# EUROPÄISCHE PATENTSCHRIFT

(11) **EP 4 431 956 B1**
(45) Veröffentlichungstag und Bekanntmachung des Hinweises auf die Patenterteilung: **25.06.2025**
(21) Anmeldenummer: 23161998.2
(22) Anmeldetag: 15.03.2023
(51) Int. Cl.: G01R 31/12, H02B 13/035, H02B 13/065

(54) **MESSUNG EINER TEILENTLADUNG EINES ELEKTRISCHEN BETRIEBSMITTELS**
MEASUREMENT OF A PARTIAL DISCHARGE OF AN ELECTRICAL OPERATING MEANS
MESURE D'UNE DÉCHARGE PARTIELLE D'UN MOYEN ÉLECTRIQUE

(43) Veröffentlichungstag der Anmeldung: 18.09.2024
(73) Patentinhaber: Siemens Aktiengesellschaft, 80333 München (DE)
(72) Erfinder: Aumann, Erhard, 67550 Worms (DE); Hain, Stefan, 91090 Effeltrich (DE); Ludwig, Klaus, 91058 Erlangen (DE); Schmidt, Jonas, 61197 Florstadt (DE)
(74) Vertreter: Siemens Patent Attorneys

(56) Entgegenhaltungen:
- EP-A1- 2 787 584
- CN-B- 108 287 288
- CN-U- 214 750 659

## Beschreibung

Unabhängig vom grammatikalischen Geschlecht eines bestimmten Begriffes sind Personen mit männlicher, weiblicher oder anderer Geschlechteridentität mit umfasst.

### HINTERGRUND DER ERFINDUNG

### Gebiet der Erfindung

Die vorliegende Erfindung betrifft ein elektrisches Betriebsmittel. Außerdem betrifft die Erfindung ein zugehöriges Verfahren zur Messung einer Teilentladung an einer elektrischen Leitungsdurchführung eines elektrischen Betriebsmittels.

### Beschreibung des Stands der Technik

Teilentladungsmessungen (TE-Messungen) sind ein standardmäßiges Verfahren zur Zustandsbewertung von elektrischen Betriebsmitteln. TE-Messungen haben sich auch bei Hoch- und Mittelspannungsschaltanlagen bewährt. Dabei kommen verschiedene Verfahren zum Einsatz, darunter UHF-Sensoren, TEV-Sensoren sowie Messmethoden im HF-Bereich wie Koppelkondensatoren oder HFCT (High Frequency Current Transformer) oder andere Messspulen. Es besteht dabei der Wunsch diese Messung häufig oder dauerhaft durchzuführen.

Dies erfordert die Nachrüstung der elektrischen Betriebsmittel mit der entsprechenden Sensorik. Damit ist ein entsprechender Aufwand verbunden, der sowohl bei Neuanlagen aber auch bei vorhanden elektrischen Betriebsmitteln die Wirtschaftlichkeit des Anwendungsfalls "TE-Messung" reduzieren oder negieren kann.

Heutzutage wird dies gelöst durch den Einbau eines HFCTs im Bereich des Hochspannungsraums von Schaltanlagen, insbesondere durch Platzieren des HFCTs um den Kabelschirm der Anschlussleitung einer Schaltanlage. Diese Lösung ist allerdings aufwendig in der Installation und Wartung.

Die Druckschrift EP 2 787 584 A1 zeigt eine elektrische Schaltanlage, die mehrere Abteile umfasst, in denen getrennt und isoliert einerseits die Elemente der elektrischen Hochspannungsverteilung und andererseits die Elemente der Niederspannungssteuerung, der Messung, einschließlich der Teilentladungsmessung, der Kommunikation, der Diagnose und des Schutzes angeordnet sind.

Die Aufgabe der Erfindung besteht darin, eine Lösung für eine verbesserte Teilentladungsmessung bereitzustellen.

### ZUSAMMENFASSUNG DER ERFINDUNG

Die Erfindung ergibt sich aus den Merkmalen der unabhängigen Ansprüche. Vorteilhafte Weiterbildungen und Ausgestaltungen sind Gegenstand der abhängigen Ansprüche. Ausgestaltungen, Anwendungsmöglichkeiten und Vorteile der Erfindung ergeben sich aus der nachfolgenden Beschreibung und den Zeichnungen. Unabhängig vom grammatikalischen Geschlecht eines bestimmten Begriffes sind Personen mit männlicher, weiblicher oder anderer Geschlechteridentität mit umfasst.

Die Erfindung betrifft ein elektrisches Betriebsmittel, aufweisend:
- Ein Hochspannungsbereich, aufweisend:
   ∘ ein Kabelanschlussraum für eine elektrische Leitungsdurchführung und
   ∘ eine kapazitive Koppelelektrode oder eine induktive Kopplung, ausgebildet einen ersten Frequenzbereich auszukoppeln,
   wobei die kapazitive Koppelelektrode oder die induktive Kopplung an der elektrischen Leitungsdurchführung angeschlossen ist,
- ein Niederspannungsbereich, aufweisend:
   ∘ ein System zur Messung hochfrequenter Ströme (insbesondere ein Hochfrequenzstromwandler (High Frequency Current Transformer HFCT), ein Shuntwiderstand, ein Magnetfeldsensor auf GMR oder ein Hall-Effekt Basis), ausgebildet einen zweiten Frequenzbereich auszukoppeln und eine Spannungsdetektion im zweiten Frequenzbereich durchzuführen,
   ∘ ein Spannungsanzeigesystem (insbesondere ein "Voltage indicator system" (VIS)), ausgebildet einen dritten Frequenzbereich zu messen und eine Spannungsdetektion im dritten Frequenzbereich durchzuführen,
   und
- die elektrische Leitungsdurchführung, aufweisend einen ersten Anschluss und einen zweiten Anschluss,
   wobei der erste Anschluss im Kabelanschlussraum angeordnet ist,
   wobei der zweite Anschluss im Niederspannungsbereich angeordnet ist und
   wobei die elektrische Leitungsdurchführung von dem Kabelanschlussraum zu dem System zur Messung hochfrequenter Ströme und zu dem Spannungsanzeigesystem verläuft.

Aus der offenbarten Anordnung ergibt sich der Vorteil, dass über die Spannungsdetektion durch das System zur Messung hochfrequenter Ströme (Hochfrequenzwandler) im zweiten Frequenzbereich eine Messung der Teilentladung erfolgt.

In dem Hochspannungsbereich liegt eine elektrische Hochspannung vor. Unter einer elektrischen Hochspannung ist im Sinne der Erfindung eine elektrische Wechselspannung größer oder gleich 1 kV (SI-Einheit Kilo Volt) und/oder elektrische Gleichspannung größer oder gleich 1,5 kV (SI-Einheit) zu verstehen.

In dem Niederspannungsbereich liegt eine elektrische Niederspannung vor. Unter einer elektrischen Niederspannung ist eine elektrische Wechselspannung bis 1000 Volt (SI-Einheit) und/oder Gleichspannungen bis 1500 Volt (SI-Einheit) zu verstehen.

Die Komponenten des Niederspannungsbereichs sind galvanisch verbunden, die restlichen Komponenten des elektrischen Betriebsmittels, insbesondere der Hochspannungsbereich, sind vom Niederspannungsbereich galvanisch getrennt.

Die induktive Kopplung ist insbesondere als eine Rogowskispule ausgebildet.

Das System zur Messung hochfrequenter Ströme ist insbesondere als wie ein Hochfrequenzstromwandler (High Frequency Current Transformer HFCT), ein Shuntwiderstand, ein Magnetfeldsensor auf GMR oder ein Hall-Effekt Basis ausgebildet.

Das Spannungsanzeigesystem ist insbesondere als ein "Voltage indicator system" (VIS) ausgebildet.

Die elektrische Leitungsdurchführung ist auch als Anschlussleitung bezeichenbar. Die Anschlussleitung weist in einer Ausführungsform insbesondere einen Kabelschirm auf. Alternativ sind ungeschirmte Kabel für die Anschlussleitung verwendbar.

Eine Kernidee dieser Erfindung ist anders ausgedrückt, den zweiten Frequenzbereich (insbesondere 100 kHz bis 100 MHz) über das System zur Messung hochfrequenter Ströme (insbesondere ein HFCT (High Frequency Current Transformer)) aus dem Signalpfad des Systems zur Spannungsdetektion auszukoppeln.

In vielen elektrischen Betriebsmitteln (wie Hoch- und Mittelspannungsschaltanlagen) ist bereits eine kapazitive Koppelelektrode (in busching verbaut) verbaut, die für eine Spannungsdetektion (d.h. für ein Übertragen des Spannungssignals von 50Hz, 100MHz...) nach IEC 62271-213 und vergleichbaren Normen eingesetzt wird oder zur allgemeinen Feldsteuerung verwendet wird. Für die Spannungsdetektion (insbesondere durch VIS) wird dabei bisher allerdings nur das 50Hz Signal verwendet. Über kapazitive Koppelelektroden wird jedoch ein weiterer Frequenzbereich ausgekoppelt, der auch die Frequenzen umfasst, die für Teilentladungsmessungen im HF-Bereich interessant sind (100 kHz bis 100 MHz). Die vorgeschlagene Lösung der Erfindung kann alternativ zu den bisherigen Lösungen eingesetzt werden.

Ein erfindungsgemäß platzierter HFCT wird physikalisch nur ein kleines Messsignal messen, da sich die Koppelkapazität (relativ gesehen sehr klein, da der komplexe Widerstand relativ gesehen sehr hoch ist) einer Durchführung erfahrungsgemäß im pF-Bereich (Picofarad) befindet. Störungen/Rauschen sind aber noch kleiner, deshalb spielt das kleine Messsignal keine Rolle.

Die vorliegende Erfindung bietet außerdem den Vorteil, dass der benötigte Bauraum des HFCT-Sensors durch die dünnen Signalleitungen sehr klein werden kann, was eine optimierte Auslegung ermöglicht. Dadurch ist außerdem eine kleinere Sensorik notwendig, da das in den Niederspannungsbereich geführte Kabel nur einen geringen Durchmesser hat.

Die vorliegende Erfindung bietet außerdem den Vorteil, dass durch eine vollständige Montage in der Fabrik eine entsprechende Kalibrierung des Systems in einem definierten Umfeld erfolgen kann. Der HFCT kann in Fabrik (beim Hersteller, nicht vor Ort beim Kunden) bereits montiert werden. Dadurch hat die vorgeschlagene Lösung folgende Vorteile:
- Vollständige Montage, Test und Kalibrierung innerhalb der Fabrik für Neuanlagen
- Vereinfachte Montage und Leitungsführung, da das (im Niederspannungsbereich der Schaltanlage durch HFCT abgegriffene) Signal nahe des Auswertesystems VIS (im Niederspannungsbereich) liegt.
- Vereinfachte Montage bei im Betrieb befindlichen Anlagen, da nur Arbeiten im Niederspannungsbereich erforderlich sind. Es ist damit keine Abschaltung im Falle einer störlichtgeprüften Schaltanlage nach IEC62271-200 notwendig.

Die vorliegende Erfindung bietet außerdem den Vorteil, dass am VDIS (=VIS) auch das 50Hz Signal (z.B. zur Erstellung eines PRPD-Patterns) ausgekoppelt werden kann, insbesondere bei VDIS nach IEC62271-213 mit dem nach diesem Standard optionalen Spannungsausgang. Aufgrund der geringen Spannungshöhe dieses Signals ist eine einfache Weiterverarbeitung möglich.

In einer Weiterbildung der Erfindung wird zwischen dem Hochspannungsbereich und dem Niederspannungsbereich ein potentialgetrennter Abgriff vorgenommen.

Durch den potentialgetrennten Abgriff liegt die Hochspannung des Hochspannungsbereich in dem Niederspannungsbereich nicht vor. Der potentialgetrennte Abgriff ist insbesondere als ein kapazitiver Abgriff ausgebildet.

Dabei ist insbesondere im Hochspannungsbereich ein kapazitiver Abgriff als erste Kapazität vorhanden und entweder im Hoch- oder Niederspannungsbereich eine zweite Impedanz viel kleiner der ersten Kapazität vorhanden. Durch den sich bildenden Teiler ist in beiden Fällen bei Ausleitungen in den Niederspannungsbereich nur eine Niederspannung vorhanden.

Bei dem Hoch- und Niederspannungsbereich handelt es sich um geschottete Bereiche im technischen Sinn. Im Niederspannungsbereich kann daher nach der Niederspannungsrichtlinie gearbeitet werden, im Hochspannungsbereich nach den Richtlinien der Hochspannung.

In einer weiteren Weiterbildung der Erfindung ist das System zur Messung hochfrequenter Ströme in dem Niederspannungsbereich angeordnet. Dies ist von Vorteil, da im Niederspannungsbereich nach der Niederspannungsrichtlinie gearbeitet werden kann.

In einer weiteren Weiterbildung der Erfindung ist das elektrisches Betriebsmittel ausgebildet als:
- ein kritisches elektrisches Betriebsmittel und/oder
- eine elektrische Schaltanlage und/oder
- eine Hochspannungsanlage und/oder
- ein Transformator und/oder
- ein Motor.

Unter einem kritischen elektrischen Betriebsmittel wird ein elektrisches Betriebsmittel verstanden, welches selbst und/oder dessen Komponenten eine kritische Funktion haben. Eine kritische Funktion ist jene, welche bei einem Ausfall zu einem weit überdurchschnittlichen Schaden, insbesondere durch Folgeschäden, führt.

Die Hochspannungsanlage weist eine elektrische Hochspannung auf. In dem Hochspannungsbereich liegt eine elektrische Hochspannung vor. Unter einer elektrischen Hochspannung ist im Sinne der Erfindung eine elektrische Wechselspannung größer oder gleich 1 kV (SI-Einheit Kilo Volt) und/oder elektrische Gleichspannung größer oder gleich 1,5 kV (SI-Einheit) zu verstehen.

In einer weiteren Weiterbildung der Erfindung liegt in dem:
- ersten Frequenzbereich eine Frequenz von 16,66 Hz bis 100 Mhz, insbesondere 50 Hz bis 100 Hz und/oder
- dritten Frequenzbereich eine Frequenz von 16,66 Hz bis 400 Hz, insbesondere 50 Hz bis 60 Hz und/oder
- zweiten Frequenzbereich eine Frequenz von 100 KHz bis 100 Mhz und/oder
vor.

Dabei wird das System zur Messung hochfrequenter Ströme, insbesondere der HFCT, vorzugsweise so ausgelegt, dass niederfrequente Störungen (insbesondere < 100 kHz) oder sehr hochfrequente Störungen (insbesondere > 100 MHz) nicht ausgekoppelt werden, um einen vorteilhaften Signal-Rausch-Abstand zu erzielen. Dies ist von Vorteil, da für die Teilentladungsmessung Frequenzen von 100 kHz bis 100 MHz besonders interessant sind.

Eine Frequenz des dritten Frequenzbereichs von 16,66 Hz ist insbesondere für Anwendungen in der Bahnfahrt relevant, eine Frequenz von 400 Hz ist insbesondere für Anwendungen in der Luftfahrt, insbesondere Flugzeugen, relevant.

In einer weiteren Weiterbildung der Erfindung verläuft die elektrische Leitungsdurchführung von dem Kabelanschlussraum über das System zur Messung hochfrequenter Ströme zu dem Spannungsanzeigesystem.

Die elektrische Leitungsdurchführung erreicht somit zuerst das System zur Messung hochfrequenter Ströme und verläuft von diesem dann weiter zu dem Spannungsanzeigesystem.

In einer weiteren Weiterbildung der Erfindung verläuft die elektrische Leitungsdurchführung von der kapazitiven Koppelelektroden zu dem System zur Messung hochfrequenter Ströme.

Die elektrische Leitungsdurchführung erreicht somit zuerst die kapazitive Koppelelektrode oder die induktive Kopplung, und verläuft von dieser dann weiter zu dem System zur Messung hochfrequenter Ströme. Insbesondere verläuft die elektrische Leitungsdurchführung anschließend weiter zu dem Spannungsanzeigesystem.

In einer weiteren Weiterbildung der Erfindung liegen der Hochspannungsbereich und der Niederspannungsbereich voneinander abgegrenzt vor. Abgegrenzt bedeutet ohne überlappenden Bereich. Es bedeutet außerdem, dass eine Abgrenzung vorliegt.

In einer weiteren Weiterbildung der Erfindung liegt zwischen dem Hochspannungsbereich und dem Niederspannungsbereich eine galvanische Trennung vor. Insbesondere ist eine Abgrenzung zwischen dem Hochspannungsbereich und dem Niederspannungsbereich somit als die galvanische Trennung ausgebildet.

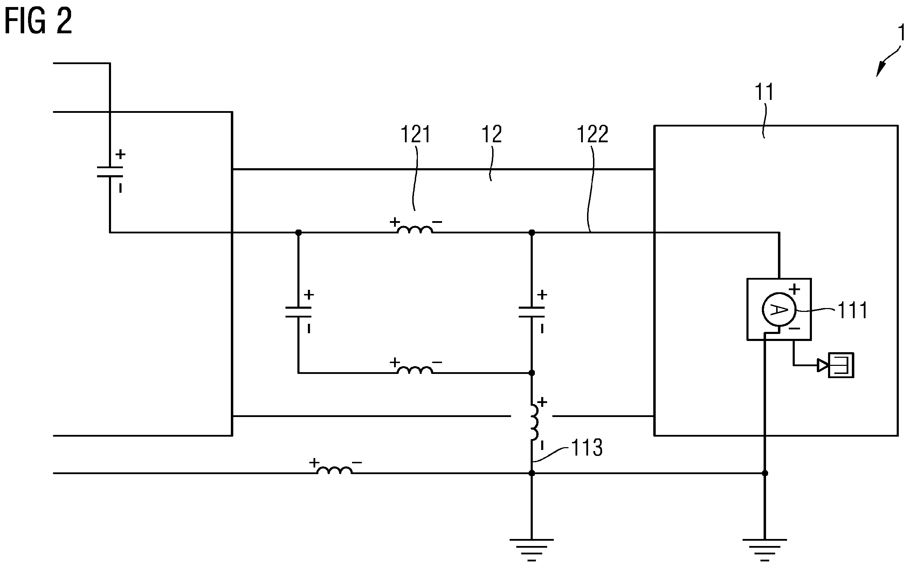

In einer weiteren Weiterbildung der Erfindung ist die elektrische Leitungsdurchführung über eine erste Induktivität im Niederspannungsbereich geerdet. Die Kabelzuführung zum IVDS (=VIS) ist somit optimiert ausgeführt: Der Kabelschirm wird nach dieser Ausführungsform vorteilhaft über die erste Induktivität nahe dem System zur Messung hochfrequenter Ströme geerdet, siehe hierzu auch Fig. 2.

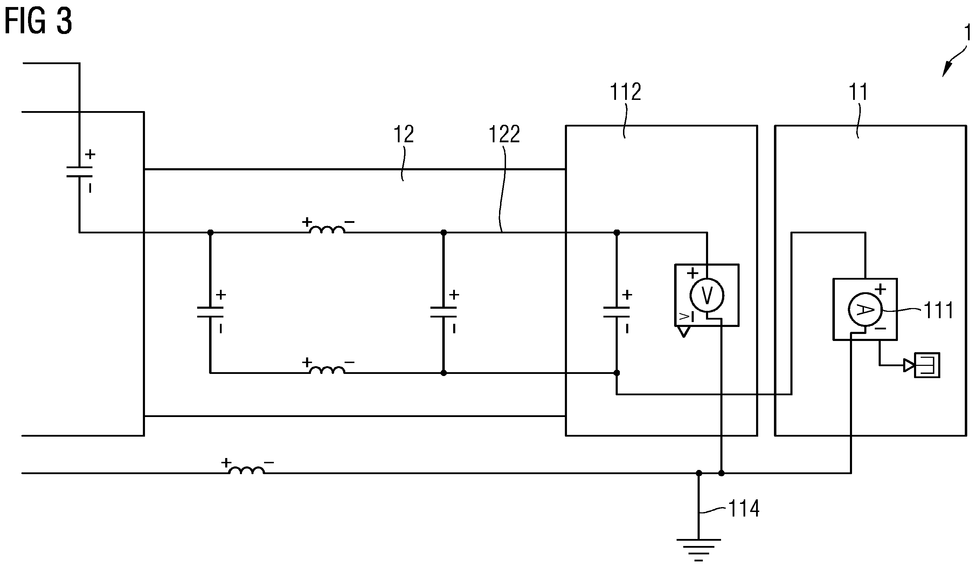

In einer weiteren Weiterbildung der Erfindung verläuft die elektrische Leitungsdurchführung gemeinsam mit einer Erdung durch das System zur Messung hochfrequenter Ströme. Die Kabelzuführung zum IVDS (=VIS) ist somit optimiert ausgeführt: Der Kabelschirm und die Erdung des IVDS (=VIS) werden nach dieser Ausführungsform gemeinsam durch den HFCT geführt, siehe hierzu auch Fig. 3.

In einer weiteren Weiterbildung der Erfindung ist die elektrische Leitungsdurchführung so ausgelegt, dass zwischen dem System zur Messung hochfrequenter Ströme und dem Kabelanschlussraum ein elektrischer Saugkreis vorliegt. Es wird somit ein Saugkreis aufgebaut, der gezielt auf für Teilentladungs- (TE-) Messungen vorteilhaften Frequenzen abgestimmt ist. Entwicklungsergebnisse haben dabei gezeigt, dass der Saugkreis durch das System zur Messung hochfrequenter Ströme, insbesondere einem Hochfrequenzstromwandler (High Frequency Current Transformer HFCT, automatisch aufgebaut wird. Das System zur Messung hochfrequenter Ströme wird vorteilshafterweise so ausgelegt, dass die vorteilshaften Frequenzen im zweiten Frequenzbereich einer Frequenz von 100 KHz bis 100 Mhz messbar sind.

In einer weiteren Weiterbildung der Erfindung weist das erfindungsgemäße elektrische Betriebsmittel außerdem auf:
- Eine zweite Induktivität, wobei die zweite Induktivität so ausgelegt ist, dass der zweite Frequenzbereich einer Faltung eines Signals einer Übertragungsfunktion von einer Teilentladungsstelle zu der kapazitiven Koppelelektrode entspricht.

Insbesondere ist das System zur Messung hochfrequenter Ströme, insbesondere der Hochfrequenzstromwandler (HFCT), selbst als die zweite Induktivität ausgebildet. Alternativ weist das System zur Messung hochfrequenter Ströme eine zusätzliche Komponente als zweite Induktivität auf.

Die zweite Induktivität und ein entstehender Saugkreis sind so aufgebaut, dass bevorzugt jener zweite Frequenzbereich gemessen wird, welcher eine Faltung eines PD-Signals einer Teilentladungsstelle, insbesondere einer Fehlstelle, mit einer Übertragungsfunktion von der Fehlstelle zu der kapazitiven Koppelelektrode herbeiführt. Erfahrungsgemäß für die Größe des elektrischen Betriebsmittels, insbesondere einer Schaltanlage und "kritische elektrische Betriebsmittel dieser" sowie isolierende Durchführungen, sind dies einzelne, spezifische Frequenzen des Bereichs von 100 KHz bis 100 Mhz. Die zweite Induktivität ist somit auf den zweiten Frequenzbereich abgestimmt.

Die Erfindung umfasst außerdem ein Verfahren zur Messung einer Teilentladung an einer elektrischen Leitungsdurchführung eines elektrischen Betriebsmittels, die folgenden Schritte auf:
- Ein Bereitstellen einer elektrischen Leitungsdurchführung, aufweisend einen ersten Anschluss und einen zweiten Anschluss,
- Ein Anordnen des ersten Anschlusses in einem Kabelanschlussraum eines Hochspannungsbereichs,
- Ein Anordnen des zweiten Anschlusses an einem Spannungsanzeigesystem in einem Niederspannungsbereich,
   so dass die elektrische Leitungsdurchführung von dem Kabelanschlussraum zu einem System zur Messung hochfrequenter Ströme und zu dem Spannungsanzeigesystem verläuft,
- Ein Auskoppeln eines ersten Frequenzbereichs durch eine kapazitive Koppelelektrode oder eine induktive Kopplung, wobei sich die kapazitive Koppelelektrode oder die induktive Kopplung in dem Hochspannungsbereich befindet,
- Ein Messen eines dritten Frequenzbereichs durch das Spannungsanzeigesystem,
- Ein Durchführen einer Spannungsdetektion im dritten Frequenzbereich durch das Spannungsanzeigesystem,
- Ein Auskoppeln eines zweiten Frequenzbereichs durch das System zur Messung hochfrequenter Ströme, und
- Die Messung der Teilentladung durch ein Durchführen einer Spannungsdetektion im zweiten Frequenzbereich durch das System zur Messung hochfrequenter Ströme.

Die Erfindung umfasst außerdem ein Verfahren zur Messung einer Teilentladung mit einem erfindungsgemäßen elektrischen Betriebsmittel.

### KURZE BESCHREIBUNG DER ZEICHNUNGEN

Die Besonderheiten und Vorteile der Erfindung werden aus den nachfolgenden Erläuterungen mehrerer Ausführungsbeispiele anhand der schematischen Zeichnungen ersichtlich.

Es zeigen
- Fig. 1: eine schematische Darstellung des erfindungsgemäßen elektrischen Betriebsmittels,
- Fig. 2: ein Schaltbild einer ersten Ausführungsform des erfindungsgemäßen elektrischen Betriebsmittels und
- Fig. 3: ein Schaltbild einer zweiten Ausführungsform des erfindungsgemäßen elektrischen Betriebsmittels.

### DETAILLIERTE BESCHREIBUNG DER ERFINDUNG

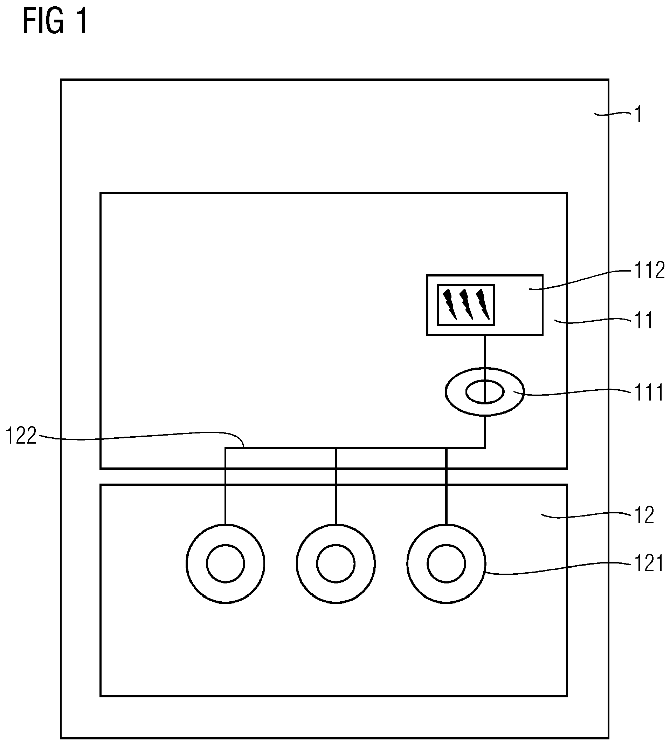

Fig. 1 zeigt eine schematische Darstellung des erfindungsgemäßen elektrischen Betriebsmittels 1 aufweisend:
- Ein Hochspannungsbereich 12, aufweisend:
   ∘ ein Kabelanschlussraum 121 für eine elektrische Leitungsdurchführung 122 und
   ∘ eine kapazitive Koppelelektrode oder eine induktive Kopplung, ausgebildet einen ersten Frequenzbereich auszukoppeln,
      wobei die kapazitive Koppelelektrode oder die induktive Kopplung an der elektrischen Leitungsdurchführung 122 angeschlossen ist,
- ein Niederspannungsbereich 11, aufweisend:
   ∘ ein System zur Messung hochfrequenter Ströme 111, ausgebildet einen zweiten Frequenzbereich auszukoppeln und eine Spannungsdetektion im zweiten Frequenzbereich durchzuführen,
   ∘ ein Spannungsanzeigesystem 112, ausgebildet einen dritten Frequenzbereich zu messen und eine Spannungsdetektion im dritten Frequenzbereich durchzuführen,
   und
- die elektrische Leitungsdurchführung 122, aufweisend einen ersten Anschluss und einen zweiten Anschluss,
   wobei der erste Anschluss im Kabelanschlussraum 121 angeordnet ist,
   wobei der zweite Anschluss im Niederspannungsbereich 11 angeordnet ist und
   wobei die elektrische Leitungsdurchführung 122 von dem Kabelanschlussraum 121 zu dem System zur Messung hochfrequenter Ströme 111 und zu dem Spannungsanzeigesystem 112 verläuft.

Fig. 2 zeigt ein Schaltbild einer ersten Ausführungsform des erfindungsgemäßen elektrischen Betriebsmittels 1. In dieser Weiterbildung der Erfindung ist die elektrische Leitungsdurchführung 122 über eine erste Induktivität 113 im Niederspannungsbereich 12 geerdet. Die Kabelzuführung 122 zum IVDS 112 (=VIS 112) ist somit optimiert ausgeführt: Der Kabelschirm wird nach dieser Ausführungsform über die erste Induktivität 113 nahe dem System zur Messung hochfrequenter Ströme 111 geerdet. Außerdem sind Komponenten gezeigt, wie bereits in Fig. 1 beschrieben.

Fig. 3 zeigt ein Schaltbild einer zweiten Ausführungsform des erfindungsgemäßen elektrischen Betriebsmittels 1. In dieser Weiterbildung der Erfindung verläuft die elektrische Leitungsdurchführung 122 gemeinsam mit einer Erdung 114 durch das System zur Messung hochfrequenter Ströme 111. Die Kabelzuführung 122 zum IVDS 112 (=VIS 112) ist somit optimiert ausgeführt: Der Kabelschirm und die Erdung 114 des IVDS 112 (=VIS 112) werden nach dieser Ausführungsform gemeinsam durch den HFCT 111 geführt. Außerdem sind Komponenten gezeigt, wie bereits in Fig. 1 beschrieben.

Obwohl die Erfindung im Detail durch die Ausführungsbeispiele näher illustriert und beschrieben wurde, ist die Erfindung durch die offenbarten Beispiele nicht eingeschränkt und andere Variationen können vom Fachmann daraus abgeleitet werden, ohne den Schutzumfang der Erfindung, der durch die Ansprüche definiert ist, zu verlassen.

## Patentansprüche

1. Elektrisches Betriebsmittel (1),
aufweisend:
- Ein Hochspannungsbereich (12), aufweisend:
∘ ein Kabelanschlussraum (121) für eine elektrische Leitungsdurchführung (122) und
∘ eine kapazitive Koppelelektrode oder eine induktive Kopplung, ausgebildet einen ersten Frequenzbereich auszukoppeln,
wobei die kapazitive Koppelelektrode oder die induktive Kopplung an der elektrischen Leitungsdurchführung (122) angeschlossen ist,
- ein Niederspannungsbereich (11), aufweisend:
∘ ein System zur Messung hochfrequenter Ströme (111), ausgebildet einen zweiten Frequenzbereich auszukoppeln und eine Spannungsdetektion im zweiten Frequenzbereich durchzuführen,
∘ ein Spannungsanzeigesystem (112), ausgebildet einen dritten Frequenzbereich zu messen und eine Spannungsdetektion im dritten Frequenzbereich durchzuführen,
und
- die elektrische Leitungsdurchführung (122), aufweisend einen ersten Anschluss und einen zweiten Anschluss, wobei der erste Anschluss im Kabelanschlussraum (121) angeordnet ist,
wobei der zweite Anschluss im Niederspannungsbereich (11) angeordnet ist und
wobei die elektrische Leitungsdurchführung (122) von dem Kabelanschlussraum (121) zu dem System zur Messung hochfrequenter Ströme (111) und zu dem Spannungsanzeigesystem (112) verläuft.

2. Elektrisches Betriebsmittel (1) nach Anspruch 1,
wobei zwischen dem Hochspannungsbereich (12) und dem Niederspannungsbereich (11) ein potentialgetrennter Abgriff vorgenommen wird.

3. Elektrisches Betriebsmittel (1) nach einem der vorhergehenden Ansprüche,
wobei das System zur Messung hochfrequenter Ströme (111) in dem Niederspannungsbereich (11) angeordnet ist.

4. Elektrisches Betriebsmittel (1) nach einem der vorhergehenden Ansprüche,
ausgebildet als:
- ein kritisches elektrisches Betriebsmittel (1) und/oder
- eine elektrische Schaltanlage (1) und/oder
- eine Hochspannungsanlage (1) und/oder
- ein Transformator (1) und/oder
- ein Motor (1).

5. Elektrisches Betriebsmittel (1) nach einem der vorhergehenden Ansprüche,
wobei in dem:
- ersten Frequenzbereich eine Frequenz von 16,66 Hz bis 100 Mhz, insbesondere 50 Hz bis 100 Hz und/oder
- dritten Frequenzbereich eine Frequenz von 16,66 Hz bis 400 Hz, insbesondere 50 Hz bis 60 Hz und/oder
- zweiten Frequenzbereich eine Frequenz von 100 KHz bis 100 Mhz und/oder
vorliegt.

6. Elektrisches Betriebsmittel (1) nach einem der vorhergehenden Ansprüche,
wobei die elektrische Leitungsdurchführung (122) von dem Kabelanschlussraum (121) über das System zur Messung hochfrequenter Ströme (111) zu dem Spannungsanzeigesystem (112) verläuft.

7. Elektrisches Betriebsmittel (1) nach einem der vorhergehenden Ansprüche,
wobei die elektrische Leitungsdurchführung (122) von der kapazitiven Koppelelektroden zu dem System zur Messung hochfrequenter Ströme (111) verläuft.

8. Elektrisches Betriebsmittel (1) nach einem der vorhergehenden Ansprüche,
wobei der Hochspannungsbereich (12) und der Niederspannungsbereich (11) voneinander abgegrenzt vorliegen.

9. Elektrisches Betriebsmittel (1) nach einem der vorhergehenden Ansprüche,
wobei zwischen dem Hochspannungsbereich (12) und dem Niederspannungsbereich (11) eine galvanische Trennung vorliegt.

10. Elektrisches Betriebsmittel (1) nach einem der vorhergehenden Ansprüche,
wobei die elektrische Leitungsdurchführung (122) über eine erste Induktivität (113) im Niederspannungsbereich (11) geerdet ist.

11. Elektrisches Betriebsmittel (1) nach einem der vorhergehenden Ansprüche,
wobei die elektrische Leitungsdurchführung (122) gemeinsam mit einer Erdung (114) durch das System zur Messung hochfrequenter Ströme (111) verläuft.

12. Elektrisches Betriebsmittel (1) nach einem der vorhergehenden Ansprüche,
wobei die elektrische Leitungsdurchführung (122) so ausgelegt ist, dass zwischen dem System zur Messung hochfrequenter Ströme (111) und dem Kabelanschlussraum (121) ein elektrischer Saugkreis vorliegt.

13. Elektrisches Betriebsmittel (1) nach einem der vorhergehenden Ansprüche,
außerdem aufweisend:
- Eine zweite Induktivität, wobei die zweite Induktivität so ausgelegt ist, dass der zweite Frequenzbereich einer Faltung eines Signals einer Übertragungsfunktion von einer Teilentladungsstelle zu der kapazitiven Koppelelektrode entspricht.

14. Verfahren zur Messung einer Teilentladung an einer elektrischen Leitungsdurchführung (122) eines elektrischen Betriebsmittels (1),
mit den Schritten:
- Ein Bereitstellen einer elektrischen Leitungsdurchführung (122), aufweisend einen ersten Anschluss und einen zweiten Anschluss,
- Ein Anordnen des ersten Anschlusses in einem Kabelanschlussraum (121) eines Hochspannungsbereichs (12),
- Ein Anordnen des zweiten Anschlusses an einem Spannungsanzeigesystem (112) in einem Niederspannungsbereich (11),
so dass die elektrische Leitungsdurchführung (122) von dem Kabelanschlussraum (121) zu einem System zur Messung hochfrequenter Ströme (111) und zu dem Spannungsanzeigesystem (112) verläuft,
- Ein Auskoppeln eines ersten Frequenzbereichs durch eine kapazitive Koppelelektrode oder eine induktive Kopplung, wobei sich die kapazitive Koppelelektrode oder die induktive Kopplung in dem Hochspannungsbereich (12) befindet,
- Ein Messen eines dritten Frequenzbereichs durch das Spannungsanzeigesystem (112),
- Ein Durchführen einer Spannungsdetektion im dritten Frequenzbereich durch das Spannungsanzeigesystem (112),
- Ein Auskoppeln eines zweiten Frequenzbereichs durch das System zur Messung hochfrequenter Ströme (111), und
- Die Messung der Teilentladung durch ein Durchführen einer Spannungsdetektion im zweiten Frequenzbereich durch das System zur Messung hochfrequenter Ströme (111).

15. Verfahren nach Anspruch 14 mit einem elektrischen Betriebsmittel (1) nach einem der Ansprüche 1 bis 13.

## Claims

1. Electrical equipment item (1),
having:
- a high-voltage region (12), having:
∘ a cable connection space (121) for an electrical cable bushing (122), and
o a capacitive coupling electrode or an inductive coupling, designed to output couple a first frequency range,
wherein the capacitive coupling electrode or the inductive coupling is connected to the electrical cable bushing (122),
- a low-voltage region (11), having:
∘ a system for measuring high-frequency currents (111), designed to output couple a second frequency range and to carry out voltage detection in the second frequency range,
∘ a voltage indicator system (112), designed to measure a third frequency range and to carry out voltage detection in the third frequency range,
and
- the electrical cable bushing (122), having a first connection and a second connection,
wherein the first connection is arranged in the cable connection space (121),
wherein the second connection is arranged in the low-voltage region (11), and
wherein the electrical cable bushing (122) runs from the cable connection space (121) to the system for measuring high-frequency currents (111) and to the voltage indicator system (112).

2. Electrical equipment item (1) according to Claim 1,
wherein a potential-isolated tap is implemented between the high-voltage region (12) and the low-voltage region (11).

3. Electrical equipment item (1) according to either of the preceding claims,
wherein the system for measuring high-frequency currents (111) is arranged in the low-voltage region (11).

4. Electrical equipment item (1), according to one of the preceding claims,
in the form of:
- a critical electrical equipment item (1) and/or
- an electrical switchgear assembly (1) and/or
- a high-voltage installation (1) and/or
- a transformer (1) and/or
- a motor (1).

5. Electrical equipment item (1) according to one of the preceding claims,
wherein:
- the first frequency range has a frequency of 16.66 Hz to 100 Mhz, in particular 50 Hz to 100 Hz and/or
- the third frequency range has a frequency of 16.66 Hz to 400 Hz, in particular 50 Hz to 60 Hz and/or
- the second frequency range has a frequency of 100 KHz to 100 Mhz.

6. Electrical equipment item (1) according to one of the preceding claims,
wherein the electrical cable bushing (122) runs from the cable connection space (121) to the voltage indicator system (112) via the system for measuring high-frequency currents (111).

7. Electrical equipment item (1) according to one of the preceding claims,
wherein the electrical cable bushing (122) runs from the capacitive coupling electrodes to the system for measuring high-frequency currents (111).

8. Electrical equipment item (1) according to one of the preceding claims,
wherein the high-voltage region (12) and the low-voltage region (11) are separated from one another.

9. Electrical equipment item (1) according to one of the preceding claims,
wherein there is galvanic isolation between the high-voltage region (12) and the low-voltage region (11).

10. Electrical equipment item (1) according to one of the preceding claims,
wherein the electrical cable bushing (122) is earthed via a first inductor (113) in the low-voltage region (11).

11. Electrical equipment item (1) according to one of the preceding claims,
wherein the electrical cable bushing (122) runs together with earthing (114) through the system for measuring high-frequency currents (111).

12. Electrical equipment item (1) according to one of the preceding claims,
wherein the electrical cable bushing (122) is configured in such a way that there is an electrical absorption circuit between the system for measuring high-frequency currents (111) and the cable connection space (121).

13. Electrical equipment item (1) according to one of the preceding claims,
furthermore having:
- a second inductor, wherein the second inductor is configured in such a way that the second frequency range of a convolution of a signal corresponds to a transfer function from a partial discharge point to the capacitive coupling electrode.

14. Method for measuring a partial discharge on an electrical cable bushing (122) of an electrical equipment item (1),
comprising the steps of:
- providing an electrical cable bushing (122), having a first connection and a second connection,
- arranging the first connection in a cable connection space (121) of a high-voltage region (12),
- arranging the second connection on a voltage indicator system (112) in a low-voltage region (11),
with the result that the electrical cable bushing (122) runs from the cable connection space (121) to a system for measuring high-frequency currents (111) and to the voltage indicator system (112),
- a capacitive coupling electrode or an inductive coupling output coupling a first frequency range, wherein the capacitive coupling electrode or the inductive coupling is in the high voltage region (12),
- the voltage indicator system (112) measuring a third frequency range,
- the voltage indicator system (112) carrying out voltage detection in the third frequency range,
- the system for measuring high-frequency currents (111) output coupling a second frequency range, and
- the system for measuring high-frequency currents (111) measuring the partial discharge by carrying out voltage detection in the second frequency range.

15. Method according to Claim 14 with an electrical equipment item (1) according to one of Claims 1 to 13.

## Revendications

1. Équipement électrique (1),
comprenant :
- une zone haute tension (12), comprenant :
∘ un espace de connexion de câble (121) pour un passage de câble électrique (122) et
∘ une électrode de couplage capacitive ou un couplage inductif, formé pour découpler une première plage de fréquences,
dans lequel l'électrode de couplage capacitive ou le couplage inductif est connecté au passage de câble électrique (122),
- une zone basse tension (11), comprenant :
∘ un système de mesure de courants à haute fréquence (111), formé pour découpler une deuxième plage de fréquences et pour effectuer une détection de tension dans la deuxième plage de fréquences,
∘ un système d'indication de tension (112), conçu pour mesurer une troisième plage de fréquences et pour effectuer une détection de tension dans la troisième plage de fréquences,
et
- le passage de câble électrique (122) comprenant un premier raccordement et un deuxième raccordement,
dans lequel le premier raccordement est disposé dans l'espace de connexion de câble (121),
dans lequel le deuxième raccordement est disposé dans la zone basse tension (11) et
dans lequel le passage de câble électrique (122) s'étend depuis l'espace de connexion de câble (121) jusqu'au système de mesure de courants à haute fréquence (111) et au système d'indication de tension (112).

2. Équipement électrique (1) selon la revendication 1, dans lequel un prélèvement à séparation de potentiel est effectué entre la zone haute tension (12) et la zone basse tension (11).

3. Équipement électrique (1) selon l'une des revendications précédentes, dans lequel le système de mesure de courants à haute fréquence (111) est disposé dans la zone basse tension (11).

4. Équipement électrique (1) selon l'une des revendications précédentes,
conçu comme :
- un équipement électrique critique (1) et/ou
- une installation de commutation électrique (1) et/ou
- une installation à haute tension (1) et/ou
- un transformateur (1) et/ou
- un moteur (1).

5. Équipement électrique (1) selon l'une des revendications précédentes,
dans lequel, dans la :
- première plage de fréquences, une fréquence de 16,66 Hz à 100 Mhz, en particulier de 50 Hz à 100 Hz et/ou
- troisième plage de fréquences, une fréquence de 16,66 Hz à 400 Hz, en particulier de 50 Hz à 60 Hz et/ou
- deuxième plage de fréquences, une fréquence de 100 KHz à 100 Mhz
est présente.

6. Équipement électrique (1) selon l'une des revendications précédentes, dans lequel le passage de câble électrique (122) s'étend depuis l'espace de connexion de câble (121) jusqu'au système d'indication de tension (112) en passant par le système de mesure de courants à haute fréquence (111).

7. Équipement électrique (1) selon l'une des revendications précédentes, dans lequel le passage de câble électrique (122) s'étend depuis les électrodes de couplage capacitives jusqu'au système de mesure de courants à haute fréquence (111).

8. Équipement électrique (1) selon l'une des revendications précédentes, dans lequel la zone haute tension (12) et la zone basse tension (11) sont délimitées l'une par rapport à l'autre.

9. Équipement électrique (1) selon l'une des revendications précédentes, dans lequel une séparation galvanique est présente entre la zone haute tension (12) et la zone basse tension (11).

10. Équipement électrique (1) selon l'une des revendications précédentes, dans lequel le passage de câble électrique (122) est mis à la terre par l'intermédiaire d'une première inductance (113) dans la zone basse tension (11).

11. Équipement électrique (1) selon l'une des revendications précédentes, dans lequel le passage de câble électrique (122) s'étend à travers le système de mesure de courants à haute fréquence (111) en même temps qu'une liaison à la terre (114).

12. Équipement électrique (1) selon l'une des revendications précédentes, dans lequel le passage de câble électrique (122) est conçu de sorte qu'il existe un circuit électrique absorbant entre le système de mesure de courants à haute fréquence (111) et l'espace de connexion de câble (121).

13. Équipement électrique (1) selon l'une des revendications précédentes,
comprenant en outre :
- une deuxième inductance, dans lequel la deuxième inductance est conçue de sorte que la deuxième plage de fréquences correspond à une convolution d'un signal d'une fonction de transfert d'un site de décharge partielle à l'électrode de couplage capacitive.

14. Procédé de mesure d'une décharge partielle sur un passage de câble électrique (122) d'un Équipement électrique (1),
comprenant les étapes :
- la mise à disposition d'un passage de câble électrique (122) comprenant un premier raccordement et un deuxième raccordement,
- l'agencement du premier raccordement dans un espace de connexion de câble (121) d'une zone haute tension (12),
- l'agencement du deuxième raccordement sur un système d'indication de tension (112) dans une zone basse tension (11),
de sorte que le passage de câble électrique (122) s'étend depuis l'espace de connexion de câble (121) jusqu'à un système de mesure de courants à haute fréquence (111) et jusqu'au système d'indication de tension (112),
- un découplage d'une première plage de fréquences par une électrode de couplage capacitive ou un couplage inductif, dans lequel l'électrode de couplage capacitive ou le couplage inductif se trouve dans la zone haute tension (12),
- une mesure d'une troisième plage de fréquences par le système d'indication de tension (112),
- une réalisation d'une détection de tension dans la troisième plage de fréquences par le système d'indication de tension (112),
- un découplage d'une deuxième plage de fréquences au moyen du système de mesure de courants à haute fréquence (111), et
- la mesure de la décharge partielle via la réalisation d'une détection de tension dans la deuxième plage de fréquences au moyen du système de mesure de courants à haute fréquence (111).

15. Procédé selon la revendication 14 avec un Équipement électrique (1) selon l'une des revendications 1 à 13.
